# EUROPEAN PATENT SPECIFICATION

(11) **EP 2 104 135 B1**
(45) Date of publication and mention of the grant of the patent: **12.06.2013**
(21) Application number: 08005334.1
(22) Date of filing: 20.03.2008
(51) Int. Cl.: H01L 21/02, H01L 21/20

(54) **A semiconductor wafer with a heteroepitaxial layer and a method for producing the wafer**
Halbleiterwafer mit Heteroepitaxialschicht und Verfahren zur Herstellung des Wafers
Plaquette semiconductrice dotée d'une couche hétéroépitaxiale et procédé pour la fabrication de la plaquette

(43) Date of publication of application: 23.09.2009
(73) Proprietor: Siltronic AG, 81737 München (DE)
(72) Inventor: Storck, Peter, Dr., 84489 Burghausen (DE); Vorderwestner, Martin, 83567 Unterreit (DE)
(74) Representative: Staudacher, Wolfgang

(56) References cited:
- EP-A1- 2 043 135
- GB-A- 2 369 490
- JP-A- 5 144 727
- US-A- 4 830 984
- US-A- 5 562 770
- US-A1- 2003 033 974
- US-A1- 2008 017 952
- DOUGLAS J PAUL ET AL: "TOPICAL REVIEW; Si/SiGe heterostructures: from material and physics to devices and circuits; Topical Review", SEMICONDUCTOR SCIENCE AND TECHNOLOGY, IOP PUBLISHING LTD, GB, vol. 19, no. 10, 1 October 2004 (2004-10-01), pages R75-R108, XP020032385, ISSN: 0268-1242, DOI: 10.1088/0268-1242/19/10/R02

## Description

A crystalline heteroepitaxial layer deposited on a single crystal substrate by epitaxial deposition typically differs from the substrate in several material properties including crystal lattice dimensions and thermal expansion coefficient. During the early stages of the deposition the heteroepitaxial layer is strained with respect to the underlying substrate lattice. After exceeding a certain layer thickness (critical thickness) the crystal of the heteroepitaxial layer starts to relax via the insertion of so called misfit dislocations (MFD). Although oriented in the plane perpendicular to the growth direction not all MFD extend to the edge of the substrate wafer but a certain number bends and forms threading dislocations (TD) propagating through the growing layer to the surface. TD forming clusters along lines are called pile-up-s (Pu) and are especially harmful for electronic devices. The stress fields from the dislocation network also cause a surface roughening called cross-hatch. The formation of MFD, Pu, TD, cross-hatch and a bending of the wafer (bow, warp) are mechanisms by which the strain from the lattice mismatch is relieved. Many epitaxial deposition techniques have been developed to reduce the negative effects of the strain relaxation on the crystal quality of the heteroepitaxial layer. SiGe deposition on Si is a well known system to increase the lattice constant from Si to pure Ge which has a lattice constant being 4.2 % larger than that of Si. Grading of the Ge concentration in the SiGe layer has been a successful way to reduce the density of TD and Pu and the surface roughness of SiGe buffer layers. Many variations of grading the Ge concentration to match the crystal lattice of Si to the intended crystal lattice constant at the surface of the graded Si₍₁₋ₓ)Geₓ buffer layer have been developed. A summary of such methods is given in Semiconductors Science and Technology, vol. 19, no.10, p. R75-R108. The current quality of SiGe buffer layers requires further improvements. Especially the intensity of the cross-hatch for higher Ge concentrations is a major challenge.

So far little attention has been given to the reactions after the deposition has ended. Typically the deposition is done by heating the substrate, e.g. a silicon wafer, to a certain temperature and then providing the components for growing a film in the gas phase (CVD, PVD, MBE etc.). When the film growth ends the film is fully or partially relaxed with regard to the substrate. Sometimes annealing steps are applied to fully relax the SiGe buffer. After the deposition is completed the cooling of the layered wafer starts. Because of the difference in thermal expansion coefficient between heteroepitaxial layer and substrate a stress is generated and the wafer bends to a certain degree resulting in a curvature of the wafer. The bowing of the wafer is a function of the film stress, the thickness of the film and the mechanical properties of the substrate.

Attempts have been made to minimize the bow of the resulting SiGe/Si structure like limiting the thickness of the heteroepitaxial layer and using intermediate layers within the SiGe buffer layer. US2008/0017952 A1, which is entirely included by reference herewith, describes a method to reduce bow caused by relaxed SiGe buffer layers by means of inserting thin strained transitional layers of silicon into the growing SiGe layer. These layers are claimed to reduce bow to a certain extent and the density of TD to less than 10⁴ cm⁻². Although this approach has some positive effect on bow, it fails in regard of reducing cross-hatch and surface-roughening.

Controlling the shape of a wafer by using front and backside layers with counteracting stress components is a well known method (US 2003/033974 A1; US 4,830,984; US 5,562,770; GB 2,369,490; JP 05,144727). Typically, thermally mismatched layers are deposited on the backside of a wafer in order to counteract the film stress generated by front side layers.

In EP 2 043 135 A1 a method is disclosed comprising depositing on the front side of a silicon substrate wafer a virtual SiGe substrate which is formed by a graded SiGe layer and a constant composition SiGe layer on top of the graded Sige layer, and depositing on the back side of the silicon substrate wafer a stress compensating layer, e.g. a Ge layer.

It is the object of the present invention to provide an appropriate solution to use stress generated by a backside layer not only for controlling the bow but for improving the quality of the SiGe epitaxial layer in particular a reduction of cross-hatch and surface roughening of SiGe layers deposited on Si substrates.

The invention provides a semiconductor wafer comprising a silicon substrate wafer having a first side and a second side; and a fully or partially relaxed graded SiGe heteroepitaxial layer on the first side of the substrate wafer and a first constant composition SiGe layer on top of the graded SiGe heteroepitaxial layer, characterized by a second constant composition SiGe layer contacting the second side of the substrate wafer, acting as stress compensating layer, and having a concentration of Ge which is from 10 to 80 %.

The invention further provides a method for producing a semiconductor wafer as claimed in claim 2.

The stress compensating layer preferably provides a tensile stress which results in a final bow of the wafer after the deposition of the front side layer and the back side layer of not less than - 27 µm and not more than +121 µm.

The claimed method comprises providing a stress compensating layer (SCL) on the backside of the substrate wafer before the wafer is cooled from a deposition temperature after the deposition of a fully or partially relaxed buffer layer (hereinafter called "heteroepitaxial layer") on the front side of the wafer. The SCL is advantageously grown in a way to provide an appropriate amount of stress for compensating the stress generated by the heteroepitaxial layer during the wafer is cooled down from the deposition temperature.

According to an approach which is not part of the claimed invention, an appropriate amount of compensating stress is achieved, if the thickness and the composition of the stress compensating layer corresponds to or is similar to the thickness of the heteroepitaxial layer. Similar composition means that the concentration of a component does not differ more than about 20 % in the heteroepitaxial layer and the stress compensating layer. Similar thickness means that the thickness of both layers does not differ more than 20 %.

According to the approach of the claimed invention, an appropriate amount of compensating stress is achieved, if the compensating stress layer comprises a constant composition SiGe layer and either the thickness or the composition of the constant composition SiGe layer or both are used for stress control. In principle, this approach is independent of the composition and thickness of the heteroepitaxial layer. Increasing the thickness of the constant composition SiGe layer or increasing the concentration of Ge in the constant composition SiGe layer or increasing both will increase the stress for compensating the stress caused by the heteroepitaxial layer during the cooling. The concentration of Ge in the constant composition SiGe layer is chosen within a range of from 10 to 80 %.

It was unexpected that, by providing a stress compensating layer in accordance with the present invention, not only the bow of the resulting wafer can be properly controlled but also cross-hatch and surface-roughness of the heteroepitaxial layer can be significantly reduced.

The inventors of the present invention conjecture that the provision of the stress compensating layer prevents a degradation of the heteroepitaxial layer during the phase after cooling down the wafer from the deposition temperature. After the deposition, the heteroepitaxial layer is in a fully or partially relaxed state depending on the conditions during deposition. When the film forming gases are turned off, the wafer is usually cooled down in a controlled manner. Due to the thermal mismatch of the substrate and the heteroepitaxial layer, new stress is generated. Because the thermal expansion cofficient of SiGe is bigger than Si the stress in the SiGe layer is tensile. This causes a set of secondary relaxation processes including the formation of secondary dislocations, roughening of the surface and also bowing of the wafer. Typically a strong increase in the density of TD and the surface roughness towards the wafer edge is observed. The claimed process providing a stress compensating layer allows to minimize the negative effect caused by the generation of new stress, to eliminate the center to edge non-uniformity in terms of RMS-roughness of the heteroepitaxial layer, to reduce the density of TD and the roughness of the heteroepitaxial layer caused by cross-hatch and to control the bow of the wafer.

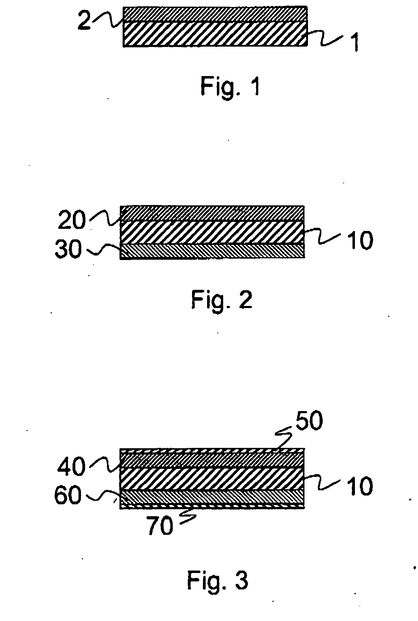

Hereinafter, reference is made to Figures 1 to 3 which do not represent the claimed invention.
Fig.1 represents an example not forming part of the invention, comprising a substrate 1 and a heteroepitaxial layer 2 deposited thereof.
Fig.2 represents a wafer comprising a substrate 10 and a heteroepitaxial layer 20 deposited on the front side of the substrate. The wafer further comprises a stress compensating layer 30 deposited on the back side of the substrate. The stress compensating layer preferably comprises a constant composition SiGe layer having an appropriate thickness and composition for compensating the stress which is caused by the heteroepitaxial layer during cooling from the deposition temperature.
Fig.3 represents an example not forming part of the invention, comprising a substrate 10 and a heteroepitaxial layer deposited on the front side of the substrate, wherein the heteroepitaxial layer comprises a graded SiGe layer 40 deposited on the front side of the substrate and a constant composition SiGe layer 50 deposited on the graded SiGe layer. The wafer further comprises a stress compensating layer deposited on the back side of the substrate, wherein the stress compensating layer comprises a graded SiGe layer 60 deposited on the back side of the substrate and a constant composition SiGe layer 70 deposited on the graded SiGe layer.

According to an approach which is not part of the claimed invention the stress compensating layer has the same or a similar composition as the heteroepitaxial layer and the same or a similar thickness as the heteroepitaxial layer.

The positive effect of the invention is demonstrated hereinafter by means of examples.

Wafers with a heteroepitaxial layer consisting of a graded SiGe layer and a constant composition SiGe layer on top of the graded SiGe layer were produced in a single wafer CVD reactor by depositing the heteroepitaxial layer on the front side of a silicon substrate wafer. The maximum concentration of germanium in the graded SiGe layer was 70%. The thickness of the graded SiGe layer was 4.6 µm. The concentration of Ge in the constant composition SiGe layer was 70%. The thickness of the constant composition SiGe layer was 1 µm. Before depositing the heteroepitaxial layer on the front side of the substrate, a stress compensating layer has been deposited on the back side of the substrate.

Several experiments were made with a constant composition Si_{0,3}Ge_{0,7} layer as stress compensating layer, wherein the thickness of the layer was varied in order to reveal the stress relieving effect on the heteroepitaxial layer. With increasing thickness of the backside layer the amount of tensile stress generated is increasing. The final bow of the wafer after deposition of front side and backside layers changes with increasing backside stress from a negative bow towards a positive bow. The examples show the improvement of the SiGe front side parameters gained by applying the backside layer over a wide range of final bow. One experiment (example 4) which does not represent the claimed invention was made with a stress compensating layer consisting of a graded SiGe layer on the substrate having a maximum concentration of germanium of 70 % and a constant composition SiGe layer on top of the graded SiGe layer. The stress generated by this type of backside is between the stress from the backside in example 3 and 5 as shown by the value of the final bow. The examples 1 to 5 show that by using stress big enough to result in a final bow of the wafer of not less than -27 µm and not more than +121 µm, the improvement of the SiGe front side layer is demonstrated.

For the purpose of comparison, two experiments were performed without providing a stress compensating layer before cooling the wafer from the deposition temperature. According to the first comparative example, a graded SiGe layer and a constant composition layer identical to the front side layer of the examples was deposited on a silicon substrate wafer. The maximum concentration of germanium in the graded layer was 70 %. The second comparative example was performed in accordance with the first comparative example, differing only in that 11 strained transitional layers of silicon as taught in US2008/0017952 A1 were provided within the graded SiGe layer for reducing the bow of the resulting wafer. The thickness of each transitional layer was 7 nm.

Further details of the experiments and the results in regard of the reduction of bow, warp, TOD and RMS-roughness are displayed in the following table. The deposition gas for depositing the the stress compensating layer and the heteroepitaxial layer was a mixture of SiCl₂H₂ and GeCl₄ in hydrogen as a carrier gas.

The density of TD was measured by microscopic inspection after Secco etching. RMS-roughness was measured with an atomic force microscope (40 x 40 pm). Warp analytics was made by using an AFS type device from ADE Corp. USA.

**Table:**

| | comp. example 1 | comp. example 2 | example 1 | example 2 | example 3 | example 4 | example 5 |
|---|---|---|---|---|---|---|---|
| grade rate | 20% / µm | 20 % / µm | 20% / µm | 20% / µm | 20% / µm | 20% / µm | 20% / µm |
| deposition temperature before cooling | 1000°C | 1050°C | 1000 °C | 1000 °C | 1000 °C | 1000 °C | 1000°C |
| thickness of the stress compensating layer | | | 2,01 µm | 2,51 µm | 3,01 µm | 5,6 µm | 4,82 µm |
| TDD (center) | 8*10⁵ /cm² | 5.0*10⁶ /cm² | 4.8*10⁵ /cm² | 4,0*10⁵ /cm² | 4,3*10⁵ /cm² | 5,4*10⁵ /cm² | 6,2*10⁵ /cm² |
| TDD (edge) | 8.7*10⁵ /cm² | > 1*10⁷ /cm² | 6,1*10⁵ /cm² | 6.3*10⁵ /cm² | 6,4*10⁵ /cm² | 6,3*10⁵ /cm² | 6,9*10⁵ /cm² |
| RMS-roughness (center) | 36,4 nm | 81,6 nm | 30 nm | 27 nm | 23,1 nm | 25,1 nm | 27,7 nm ' |
| RMS-roughness (edqe) | 150,4 nm | 186,1 nm | 37,9 nm | 33,5 nm | 57,3 nm | 43,7 nm | 41,5 nm |
| Bow | -157 µm | -65 µm | -27 µm | 2 µm | 37 µm | 54 µm | 121 µm |
| Warp | 290 µm | 132 µm | 56 µm | 32 µm | 96 µm | 125 µm | 274 µm |

## Claims

1. A semiconductor wafer comprising
a silicon substrate wafer having a first side and a second side; and
a fully or partially relaxed graded SiGe heteroepitaxial layer on the first side of the substrate wafer and a first constant composition SiGe layer on top of the graded SiGe heteroepitaxial layer, **characterized by** a second constant composition SiGe layer contacting the second side of the substrate wafer, acting as stress compensating layer and having a concentration of Ge which is from 10 to 80 %.

2. A method for producing a semiconductor wafer, comprising
depositing at a deposition temperature on a first side of a silicon substrate wafer a fully or partially relaxed graded SiGe heteroepitaxial layer and a first constant composition SiGe layer on top of the graded SiGe heteroepitaxial layer, **characterized by**
before cooling the wafer from the deposition temperature, providing a stress compensating layer on a second side of the substrate wafer, wherein the stress compensating layer is provided before or during depositing the fully or partially relaxed graded SiGe heteroepitaxial layer on the first side of the substrate wafer by depositing a second constant composition SiGe layer contacting the second side of the substrate wafer and having a concentration of Ge which is from 10 to 80 %.

## Patentansprüche

1. Halbleiterwafer, der Folgendes umfasst:
einen Siliziumsubstratwafer mit einer ersten Seite und
einer zweiten Seite und
eine ganz oder teilweise relaxierte abgestufte SiGe-Heteroepitaxialschicht auf der ersten Seite des Substratwafers und eine erste SiGe-Schicht mit konstanter Zusammensetzung auf der abgestuften SiGe-Heteroepitaxialschicht, **gekennzeichnet durch** eine zweite SiGe-Schicht mit konstanter Zusammensetzung, die die zweite Seite des Substratwafers kontaktiert, als eine Stresskompensationsschicht wirkt und eine Konzentration von Ge aufweist, die zwischen 10 und 80% liegt.

2. Verfahren zum Herstellen eines Halbleiterwafers, das Folgendes umfasst:
Abscheiden einer ganz oder teilweise relaxierten abgestuften SiGe-Heteroepitaxialschicht bei einer Abscheidungstemperatur auf einer ersten Seite eines Siliziumsubstratwafers und einer ersten SiGe-Schicht mit konstanter Zusammensetzung auf der abgestuften SiGe-Heteroepitaxialschicht, **gekennzeichnet durch**:
Bereitstellen einer Stresskompensationsschicht auf einer zweiten Seite des Substratwafers vor dem Abkühlen des Wafers von der Abscheidungstemperatur, wobei die Stresskompensationsschicht vor oder während des Abscheidens der ganz oder teilweise relaxierten abgestuften SiGe-Heteroepitaxialschicht auf der ersten Seite des Substratwafers **durch** Abscheiden einer zweiten SiGe-Schicht mit konstanter Zusammensetzung, die die zweite Seite des Substratwafers kontaktiert und eine Konzentration von Ge aufweist, die zwischen 10 und 80% liegt, bereitgestellt wird.

## Revendications

1. Plaquette semi-conductrice comprenant
une plaquette substrat en silicium ayant un premier côté et un deuxième côté ; et
une couche hétéroépitaxiale de SiGe à gradient totalement ou partiellement relaxée sur le premier côté de la plaquette substrat et une première couche de SiGe à composition constante au-dessus de la couche hétéroépitaxiale de SiGe à gradient, **caractérisée par**
une deuxième couche de SiGe à composition constante en contact avec le deuxième côté de la plaquette substrat, agissant comme couche de compensation des contraintes et ayant une concentration de Ge qui est de 10 à 80 %.

2. Procédé de production d'une plaquette semi-conductrice, comprenant
le dépôt à une température de dépôt sur un premier côté d'une plaquette substrat en silicium d'une couche hétéroépitaxiale de SiGe à gradient totalement ou partiellement relaxée et d'une première couche de SiGe à composition constante au-dessus de la couche hétéroépitaxiale de SiGe à gradient, **caractérisé par**
avant le refroidissement de la plaquette depuis la température de dépôt, l'obtention d'une couche de compensation des contraintes sur un deuxième côté de la plaquette substrat, la couche de compensation des contraintes étant obtenue avant ou pendant le dépôt de la couche hétéroépitaxiale de SiGe à gradient totalement ou partiellement relaxée sur le premier côté de la plaquette substrat par dépôt d'une deuxième couche de SiGe à composition constante en contact avec le deuxième côté de la plaquette substrat et ayant une concentration de Ge qui est de 10 à 80 %.
